# EUROPEAN PATENT SPECIFICATION

(11) **EP 0 437 376 B1**
(45) Date of publication and mention of the grant of the patent: **19.03.1997**
(21) Application number: 91300207.7
(22) Date of filing: 11.01.1991
(51) Int. Cl.: G03F 1/14

(54) **Phase shifting masks and methods of manufacture**
Phasenverschiebungsmaske und Verfahren zur Herstellung
Masque à décalage de phase et méthode de fabrication

(30) Priority: 12.01.1990 JP 5606/90; 20.03.1990 JP 69979/90; 02.05.1990 JP 116464/90
(43) Date of publication of application: 17.07.1991
(60) Divisional application: 96102706.7
(73) Proprietor: SONY CORPORATION, Tokyo 141 (JP)
(72) Inventor: Shimizu, Hideo, c/o Patents Division Sony Corp., Shinagawa-ku, Tokyo 141 (JP); Kawahira, Hiroichi, c/o Patents Division Sony Corp, Shinagawa-ku, Tokyo 141 (JP)
(74) Representative: Pilch, Adam John Michael

(56) References cited:
- EP-A- 0 090 924
- EP-A- 0 234 547
- EP-A- 0 383 534
- EP-A- 0 395 425
- EP-A- 0 401 795

## Description

This invention relates to phase shifting masks and to methods of manufacturing such masks, which can be used in the formation of a variety of patterns, such as resist patterns in the process of manufacturing semiconductor devices.

In semiconductor and similar devices, the processing dimensions tend to become increasingly smaller. In the technology of photolithography employed for manufacture of such miniaturised semiconductor devices, there is known, as a means for further enhancing the resolution, a phase shifting technique which causes a phase difference in the light transmitted through a mask and thereby improves the light intensity profile.

This phase shifting method is disclosed, for example, in Japanese Patent Laid-open No. Sho 58 (1983)-173744; in Marc D. Levenson et al., "Improving Resolution in Photolithography with a Phase Shifting Mask", IEEE Transactions on Electron Devices, Vol. ED-29, No. 12, December 1982, pp. 1828 - 1836; and in Marc D. Levenson et al., "The Phase Shifting Mask II; Imaging Simulations and Submicrometer Resist Exposures", Transactions on Electron Devices, Vol. ED-31, No. 6, June 1984, pp. 753 - 763.

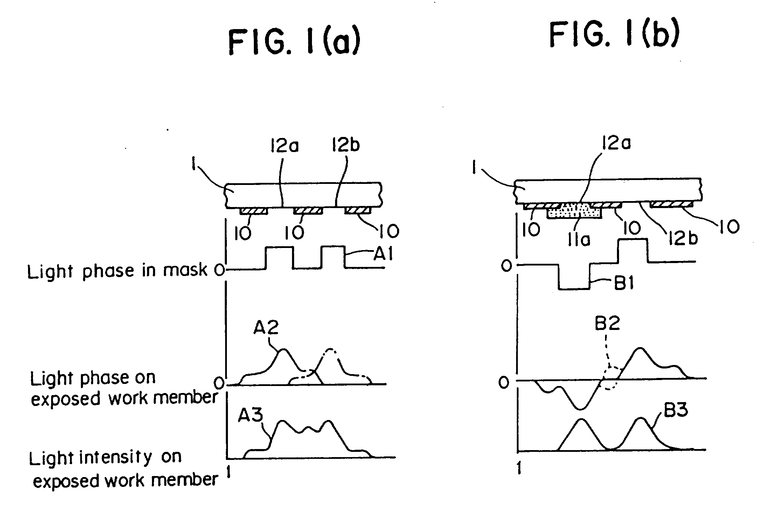

The previously-proposed phase shifting method will now be described with reference to Figures 1(a) and 1(b) of the accompanying drawings. In an exemplary case of forming a line-and-space pattern, as shown in Figure 1(a), a light shielding region 10 is formed by the use of a light shielding material such as chromium on a transparent substrate 1 of quartz or the like, and an arrangement of repeated line-and-space patterns is formed to produce an exposure mask. The intensity distribution of the light transmitted through such an exposure mask is represented by a curve A1 in Figure 1(a), wherein the intensity is zero at the light shielding regions 10 while the light is transmitted through the other regions (light transmitting segments 12a, 12b) to provide constant light intensity levels. Viewing one light transmitting segment 12a as an example, the intensity of the light transmitted therethrough and irradiated on a work member to be exposed is distributed as represented by a curve A2 in Figure 1(a), wherein hill-like maxima have flatter regions on either side due to the diffraction of the light. The light passing through the light transmitting segment 12b is represented by a one-dot chained line which is similar to, but dimensionally displaced from, the curve A2. When the light patterns provided by means of the individual transmitting segments 12a, 12b are combined, the light intensity distribution loses its sharpness as indicated by a curve A3, consequently blurring the image due to diffraction of the light, and hence failing to provide a sharp exposure. In contrast therewith, if phase shifting films are provided on the light transmitting segments of the repeated patterns alternately as shown in Figure 1(b), any blur of the image resulting from diffraction of the light is eliminated by inversion of the phase resulting in a sharp image and thereby improving the resolution and the focusing performance. More particularly, when a phase shifting film 11a is formed on the light transmitting segment 12a as shown in Figure 1(b) in such a manner as to cause a phase shift of 180° for example, the light passed through the phase shifting film 11a is inverted, as represented by a curve B1. The light obtained through the adjacent light transmitting segment 12a does not pass through a phase shifting film so that there is no such phase inversion. Therefore, on the work member to be exposed, the mutually phase-inverted light beams cancel each other at a position B2 corresponding to the flatter regions of the light intensity distribution, whereby the distribution of the light irradiated on the work member is sharpened, as represented by a curve B3 in Figure 1(b).

In the example mentioned above, the greatest advantage is attainable by causing a 180° phase inversion. However, in order to realise such a satisfactory result, it is necessary for the phase shifting film 11a to have a thickness d = λ/2(n-1) (where n denotes the refractive index of the phase shifting film, and λ denotes the wavelength of the exposure light).

In the process of forming a pattern by exposure, a member used for reduced-size projection may be termed a reticle, and a member for actual-size projection may then be termed a mask; alternatively a member corresponding to an original sheet may be termed a reticle, and a member obtained by duplicating such a reticle may then be termed a mask. In the present description, any one of the masks and reticles classified by such various definitions is generally termed a mask.

Although the above technique utilising the previously-proposed phase shifting mask is very effective for forming an arrangement of repeated patterns such as the line-and-space patterns shown in Figure 1(b), there still exists a problem that such a mask is not readily usable in forming isolated patterns which are not repetitive.

As described above, the phase shifting technique causes a phase difference between the light beams for exposure of mutually adjacent patterns, and utilises the effect that the respective overlapping light intensities cancel each other. However, since mutually proximate light beams are not present in the case of forming an isolated line or a contact hole, the above phase shifting technique is not directly applicable.

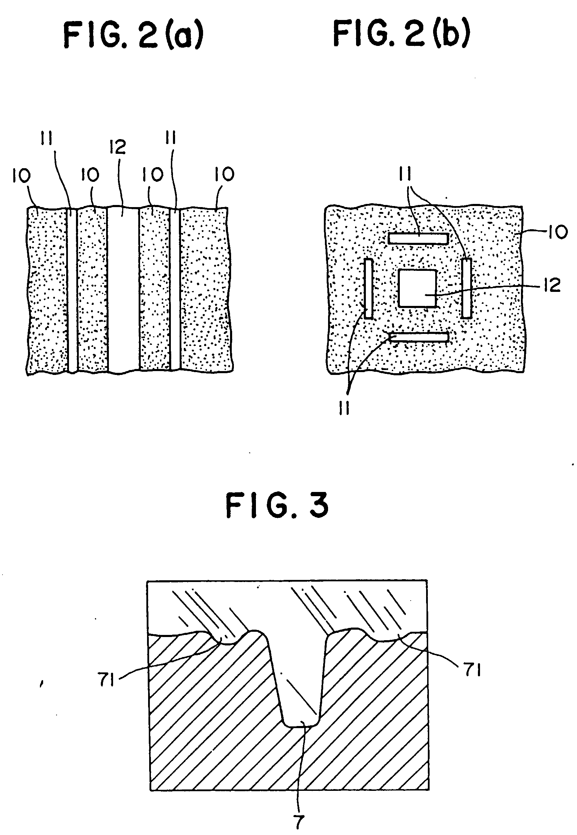

It has therefore been necessary in such cases, as illustrated in Figures 2(a) and 2(b), for a light transmitting region 12 for transmitting exposure light therethrough without causing any phase shift (phase shift 0°) to be provided in conformity with a desired pattern to be formed, and a phase shifting region 11 for causing a phase shift of exposure light (such as a phase shift of 180°) to be provided in the proximity of the light transmitting region 12. (Terasawa et al., Second Draft for Lecture in 49th Applied Physics Society Meeting, Autumn 1988, p. 497, 4a-K-7).

In such an arrangement, a main space is required for constituting a pattern-forming light transmitting segment 12 within a light shielding region 10, and further a sub-space is also required for constituting the phase shifting segments 11. The phase shifting segments 11 are formed along the two sides of and in the proximity of a rectangularly extending light transmitting region 12 which is a main space in the mask of Figure 2(a) for forming an isolated line pattern; alternatively the segments 11 are formed along and in the proximity of four sides of a square light transmitting region 12 in the mask of Figure 2(b) for forming a hole pattern.

In the previously-proposed arrangements of Figures 2(a) and 2(b), the light transmitting segment 12 and the phase shifting segment 11 need to be spaced apart from each other since an insufficient distance therebetween will cause excessive cancellation of the respective light intensities, consequently reducing the transfer pattern. Therefore it is necessary to provide a relatively large area for forming each pattern.

Furthermore, the phase shifting segment 11 needs to have certain dimensions since the effect thereof is diminished in accordance with a dimensional decrease. As a result, there arises another problem in that the pattern of the phase shifting segment 11 is itself transferred. Figure 3 illustrates an exemplary case in which an isolated space 7 is formed by using the mask of Figure 2(a). As shown with some exaggeration in Figure 3, it is unavoidable that patterns 71 derived directly from the phase shifting segments 11 are also formed.

European Patent Applications EP-A-0 090 924 and EP-A-0 234 547 disclose further mask manufacturing methods.

According to the present invention there is provided a method of manufacturing a phase shifting mask, the method comprising the steps of:
forming a light shielding layer on a substrate;
forming a photoresist on said light shielding layer;
patterning said photoresist to form a resist pattern;
forming an opening in said light shielding layer by the use of said resist pattern as a mask, thereby forming a light shielding pattern;
side etching said light shielding pattern to form a light shielding region;
depositing a phase shifting material in said opening to form a phase shifting segment by the use of said resist pattern as a mask such that some phase shifting material is deposited on said resist pattern, whereby the thickness of the phase shifting segment is set depending on the amount of phase shifting material deposited; and
removing said resist pattern together with phase shifting material leaving the phase shifting segment in said opening.

Embodiments of the present invention provide improved methods of manufacturing a phase shifting mask, which are capable of minimising the number of required steps, particularly by overcoming the necessity of executing a plotting step twice to obtain a mask of a desired structure.

The invention will now be described by way of example with reference to the accompanying drawings, throughout which like parts are referred to by like references, and in which:
Figures 1(a) and 1(b) illustrate the principle of a phase shifting exposure mask;
Figures 2(a) and 2(b) illustrate exemplary structures of previously-proposed phase shifting masks;
Figure 3 is a partially sectional perspective view of a work member prepared using the mask of Figure 2(a);
Figures 4(a) and 4(b) are plan views illustrating the structures of exemplary phase shifting masks;
Figures 5(a) to 5(c) and Figures 6(a) to 6(c) graphically show light intensity distributions;
Figures 7(a) to 7(f) illustrate sequential steps in manufacture according to one method which is for technical information only and is not within the scope of the claim , with sectional views of a phase shifting mask during these steps; and
Figures 8(d) to 8(f) similarly illustrate later sequential steps of an embodiment of the invention, the earlier steps being as shown in Figures 7(a) to 7(c).

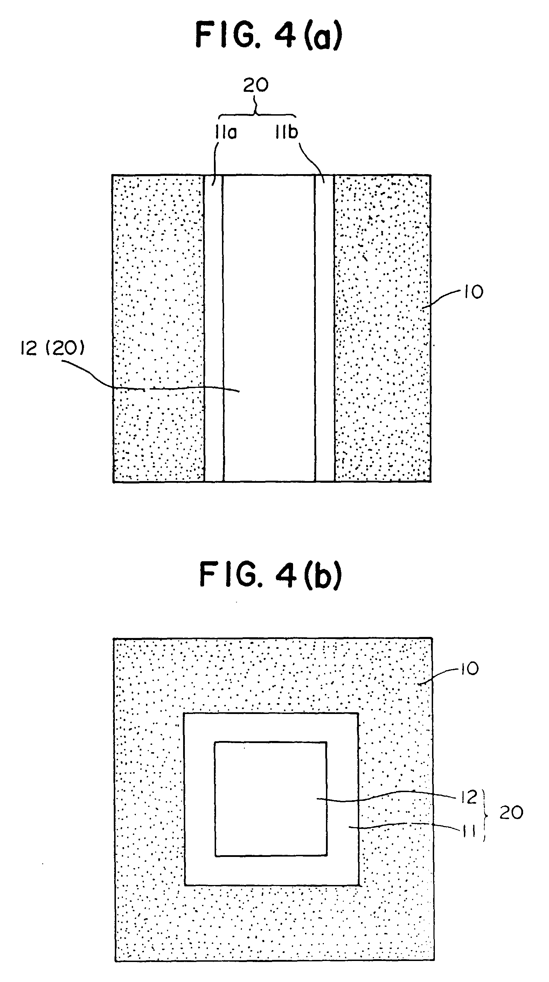

As illustrated in Figures 4(a) and 4(b), phase shifting masks which can be produced by methods embodying the present invention each comprise a transparent region 20 (transparent with respect to exposure light) and a light shielding region 10. The transparent region 20 has a light transmitting segment 12 for directly transmitting the exposure light therethrough, and phase shifting segments 11, 11a, 11b for transmitting the exposure light therethrough with a phase difference from the light transmitted through the light transmitting segment 12. The light shielding region 10 is formed so as to be adjacent at least the phase shifting segments 11, 11a, 11b or the light transmitting segment 12. The light transmitting segment 12 may be composed so as to permit transmission of the exposure light without any phase shift.

In both the examples of Figures 4(a) and 4(b), the light shielding region 10 is positioned adjacent the phase shifting segments 11, 11a, 11b. However, the arrangement may be modified so that the light shielding region 10 is adjacent the light transmitting segment 12. More specifically, in the example of Figure 4(a), two rows of phase shifting segments 11a, 11b are formed adjacent respective sides of a light transmitting segment 12 corresponding to an isolated line (space) pattern, and the phase shifting segments 11a, 11b are positioned adjacent the surrounding light shielding region 10. However, the above arrangement may be modified so that a phase shifting segment of a shape corresponding to a desired pattern may be formed at the centre, and rows of light transmitting segments may be formed on respective sides of the phase shifting segment region, in such a manner that the light transmitting segments and the light shielding region 10 adjoin mutually.

Further, in the example of Figure 4(b), a phase shifting segment 11 is formed adjacent a light transmitting segment 12 which corresponds to a desired hole pattern, in a manner to surround the four sides of the light transmitting segment 12, and the phase shifting segment 11 adjoins the peripheral light shielding region 10. However, this arrangement may be modified so that a phase shifting segment of a shape corresponding to a desired hole pattern is formed at the centre, while a light transmitting segment is formed in a manner which surrounds the phase shifting segment, and the light transmitting segment and the light shielding segment 10 adjoin mutually.

Regarding the exemplary structures illustrated in Figures 4(a) and 4(b), the same phase shifting effect can be attained even in each of the modifications where the phase shifting segments 11, 11a, 11b are positionally interchanged with the light transmitting segment 12. This will be easily understood from the principle of a phase shifting mask, namely that the phases of mutually proximate light beams cancel each other thereby enhancing the resolution.

In embodying the present invention, a transparent region 20 on a mask is generally divided into two mutually adjacent segments, and these segments are composed so as to cause a phase difference between exposure light transmitted therethrough. The effect thereby achieved is optimised when the phase difference is 180°.

In the present phase shifting technique, the light transmitted through the periphery of the central area (light transmitting segment 12 in Figures 4(a) and 4(b)) of the transparent region 20 is cancelled by the light transmitted through the outer difference-phase areas (phase shifting segments 11, 11a, 11b in Figures 4(a) and 4(b)), so that the intensity of the former light is rendered lower than the intensity obtained in a different structure where the central area (light transmitting segment 12) alone is present. Therefore, the resultant pattern becomes considerably smaller as compared to the pattern exposed and transferred in the structure where merely the central area (light transmitting segment 12) is present. For this reason, the central area (light transmitting segment 12) is formed to be greater than the size of the desired pattern to be obtained so that it becomes possible to transfer a pattern of the desired size. Also, the resolution of the pattern thus obtained can be enhanced due to the effect of the phase shifting process.

In an exemplary case of transferring a contact hole pattern by the use of the above-described structure, the following effects are attainable. This example represents a case in which there is formed a contact hole of a 0.15- µm square by using a KrF excimer laser (light wavelength 248 nm).

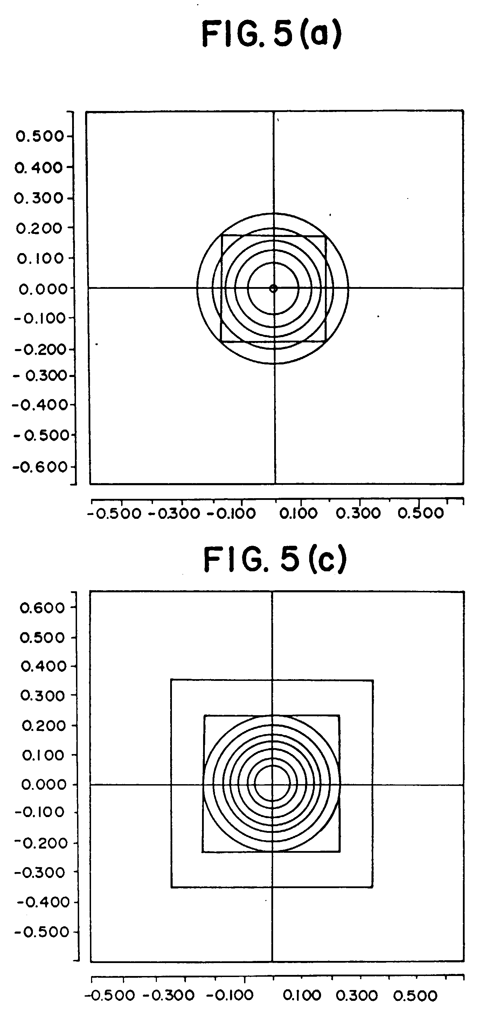

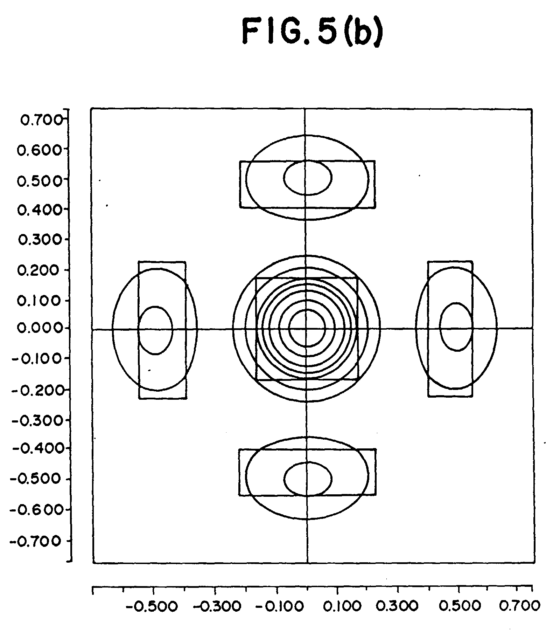

According to a previously-proposed exposure mask obtained merely with a pattern of a 0.35- µm square transparent region without employment of the phase shifting technique, the light intensity distribution on a wafer or a similar work member to be exposed becomes as graphically shown in Figure 5(a). In the case of using another previously-proposed mask as shown in Figure 2(b) which utilises the phase shifting technique, the light intensity is increased as graphically shown in Figure 5(b). However, since a sub-space (Figure 2(b)) constituting a phase shifting segment 11 alone has a light intensity to a certain degree, its pattern may possibly be transferred as well. In contrast to this, when the mask of Figure 4(b) is employed, the light intensity can be increased solely in the hole area as graphically shown in Figure 5(c).

In Figures 5(a) to 5(c), the light intensities denote the results of calculations, and the values thereof are indicated by equi-intensity curves on the exposure surface. In each diagram, the abscissa and ordinate represent lengths in µm.

As will be apparent from the comparison of the diagrams of Figures 5(a) to 5(c), if the central area (light transmitting segment 12 of Figure 4(b)) of the transparent region 20 in the present embodiment of Figure 5(c) is formed to be a 0.46- µm square and the peripheral opening is formed to be a 0.70- µm square, then substantially the same light intensity distribution as that of Figure 5(b) can be obtained.

Thus, according to the present phase shifting mask technique, the space can be minimised without inducing transfer of any unrequired pattern, hence ensuring a high resolution.

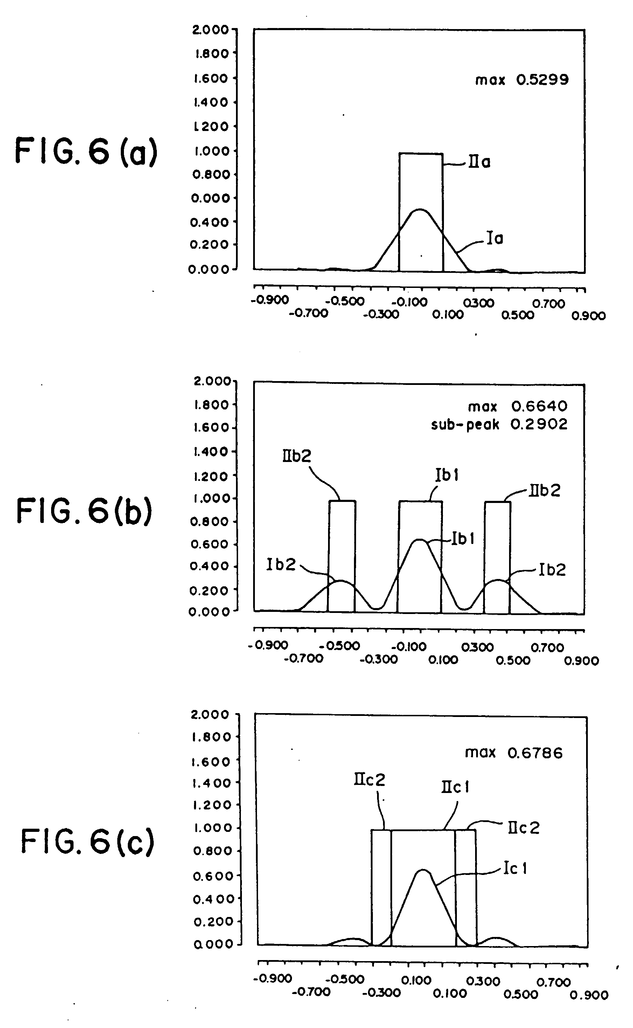

Each of Figures 6(a) to 6(c) graphically shows the light intensity distribution obtained on an exposed work member such as a wafer by the use of a KrF excimer laser in transferring an isolated line pattern of 0.25 µm in width. In these graphs, the abscissa represents length in µm, and the ordinate represents an absolute value of the light intensity on the exposed work member with the irradiated light regarded as unity.

Figure 6(a) graphically shows the result obtained relative to a previously-proposed mask without using the phase shifting technique, wherein the light intensity distribution Ia on the exposed work member is curved in conformity with the irradiated light IIa passed through the light transmitting segment of the mask. The maximum light intensity in the distribution Ia on the exposed work member was 0.5299.

Figure 6(b) graphically shows the result obtained by a previously-proposed phase shifting mask according to Figure 2(a). The intensity distribution Ib1 of the pattern exposure light corresponding to the irradiated light IIb1 through the light transmitting segment 12 in Figure 2(a) indicates a major maximum intensity of 0.6640. However, a sub-peak is generated in the intensity distribution Ib2 of the irradiated light IIb2 through the phase shifting segment 11, and its maximum value of 0.2902 is considerable. This signifies that the possibility of transfer of an unrequired pattern is high.

In contrast therewith, the result obtained relative to the embodiment of Figure 4(a) is graphically shown in Figure 6(c), wherein the light intensity distribution Ic1 on the exposed work member corresponding to the irradiated light IIc1 through the light transmitting segment 12 in Figure 4(a) indicates a maximum intensity of 0.6786 which is greater than any of the previous values. It is further apparent that substantially no peak is generated in the phase shifting segments 11a, 11b of Figure 4(a) corresponding to the irradiated light IIc2, hence preventing transfer of any unrequired pattern.

Various methods of manufacturing phase shifting masks, such as those of Figures 4(a) and 4(b), will now be described.

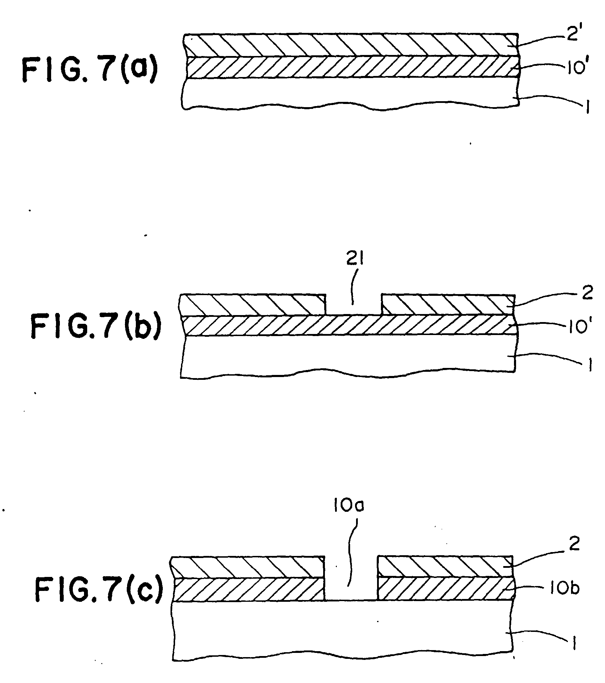

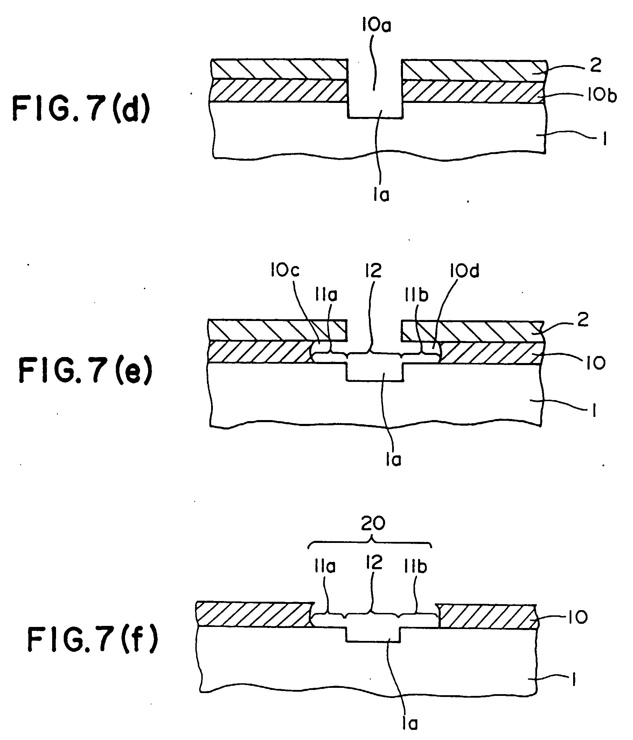

A first method which is for technical information only and is not within the scope of the claim comprises the following steps as illustrated in Figures 7(a) to 7(f). An opening is provided in a light shielding layer to form a light shielding pattern, and then the light shielding pattern is processed by side-etching while being masked with a photoresist to form a light shielding region of the phase shifting mask.

Further details of this method will now be described with reference to Figures 7(a) to 7(f). In this method, a film of a material having light shielding properties (for example, chromium or any other material such as a heavy metal or oxide thereof suited to shield exposure light) is formed as a light shielding layer 10' on a substrate 1 (of silicon dioxide or the like) having light transmitting properties; and a photoresist 2' is formed as a film on the light shielding layer 10' by coating or the like thereby to produce a structure as shown in Figure 7(a).

Subsequently an electron beam (EB) plotting step is executed, and the photoresist 2' is patterned thereby to form a resist pattern 2 with a resist opening 21, as illustrated in Figure 7(b).

In the next step, a light shielding pattern 10b with an opening 10a is obtained by the normal technique of photolithography while being masked with the resist pattern 2, as illustrated in Figure 7(c). Since the opening 10a corresponds to the phase shifting segment 12 (see Figure 7(f)) of a final desired structure, both the opening 10a and the resist opening 21 are formed in conformity therewith.

Thus, the resist pattern 2 is obtained by EB-plotting and developing the resist 2', and the light shielding layer 10' is patterned by etching or the like while being masked with the resist pattern 2. Until this stage, the processing steps are the same as those adopted in manufacture of an ordinary reticle, and therefore known techniques may be employed.

Subsequently in this method, the substrate 1 is etched while being masked directly with the resist pattern 2, whereby a recess 1a is formed in the substrate as illustrated in Figure 7(d). The etching depth d (depth of the recess 1a) is selectively determined as d = λ/2(n-1) where λ denotes the wavelength of light employed for exposure, and n denotes the refractive index of the substrate 1 to the exposure light. The phase shifting effect is maximised when the above condition is satisfied.

Subsequently, the light shielding pattern 10b is side-etched while being masked with the resist pattern 2, whereby a structure as shown in Figure 7(e) is obtained, with a light shielding region 10 in which the light shielding pattern 10b is partially etched on both sides of the recess 1a in the substrate 1. Portions 10c, 10d are removed from the light shielding pattern 10b by the etching in this step.

In the above process, "side etching" signifies etching in a lateral direction (leftward-rightward lateral direction in the drawing) orthogonal to the depth of the light shielding pattern 10b (upward-downward vertical direction in the drawing). Such side etching can be executed with a suitable agent which causes an erosive action on the material of the light shielding pattern 10b. For example, the side etching can be effected in a wet etching mode with a selected etching liquid which meets the above requirement. Since the side-etched portions 10c, 10d correspond to the light transmitting segments 11a, 11b respectively as illustrated in Figure 7(e), the amount of such etching is determined in conformity with the desired size.

Finally, the resist pattern 2 is removed to produce a phase shifting mask structure as shown in Figure 7(f), which comprises a transparent region 20 with respect to exposure light and a light shielding region 10 for shielding the exposure light, wherein the transparent region 20 has light transmitting segments 11a, 11b for directly transmitting the exposure light therethrough, and the phase shifting segment 12 for transmitting exposure light therethrough with a phase difference from the light passed through the light transmitting segments.

The plan-view constitution of the phase shifting mask may be shaped into a contact hole pattern as shown in Figure 4(b) or a line (space) pattern as shown in Figure 4(a).

According to the method described above, a desired structure can be achieved with only a single plotting step (Figure 7(b)), which step requires the highest precision and the longest time.

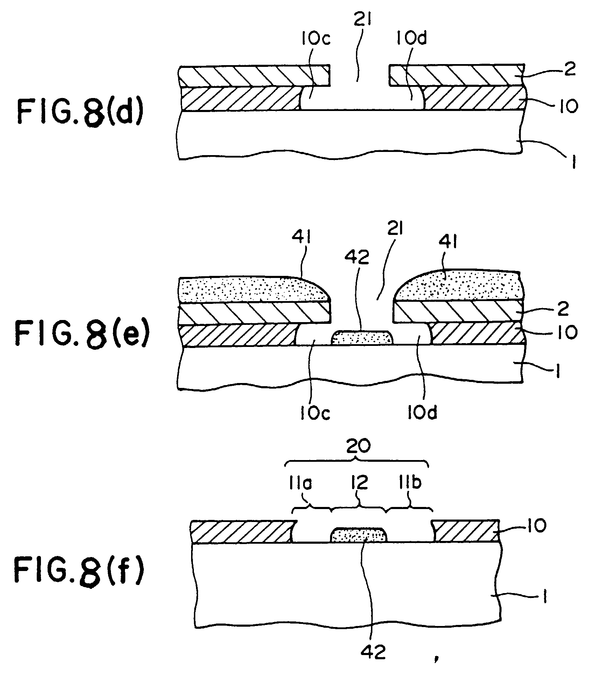

In comparison with the first method shown in Figures 7(a) to 7(f) in which segments for causing a phase difference between light rays transmitted therethrough are formed by partially changing the thickness of the substrate 1, an embodiment of the invention shown in Figures 8(d) to 8(f) is arranged so as to form a projection 42 on the substrate 1, the projection 42 being formed from a suitable material having a phase shifting effect, wherein the projection is used as the phase shifting region 12 (see Figure 8(f)).

In manufacture of this embodiment of the invention, the same steps as those for the first method which is for technical information and is not within the scope of the claim are executed in an early stage. More specifically, the steps of Figures 7(a) to 7(c) are initially performed; accordingly a detailed description of these steps will not be given here. After the step of Figure 7(c), first the light shielding pattern 10b is side-etched to obtain a structure as shown in Figure 8(d) with portions 10c, 10d where the light shielding layer has been removed. Thus, in contrast with the first method in which the substrate 1 is etched, such etching is not executed in this embodiment and side etching is started immediately.

A suitable material having a phase shifting effect, such as silicon dioxide, is then evaporated by means of chemical vapour deposition (CVD) or the like, thereby forming the projection 42 of phase shifting material of a size corresponding to a resist opening 21 in the resist pattern 2, as illustrated in Figure 8(e). Simultaneously therewith, a film 41 of phase shifting material is formed on the resist pattern 2 as well.

With subsequent removal of the resist pattern 2, the film 41 is also removed, consequently providing a phase shifting mask structure as shown in Figure 8(f) which comprises a light shielding region 10 and a transparent region 20 having a phase shifting segment 12 composed of the phase shifting projection 42 and the light transmitting segments 11a, 11b formed by the side etching step.

In this embodiment also, merely a single plotting step is sufficient, as in the previous method.

## Claims

1. A method of manufacturing a phase shifting mask, the method comprising the steps of:
forming a light shielding layer (10') on a substrate (1);
forming a photoresist (2') on said light shielding layer (10');
patterning said photoresist (2') to form a resist pattern (2);
forming an opening (10a) in said light shielding layer (10') by the use of said resist pattern (2) as a mask, thereby forming a light shielding pattern (10b);
side etching said light shielding pattern (10b) to form a light shielding region (10);
depositing a phase shifting material in said opening (10a) to form a phase shifting segment (42) by the use of said resist pattern (2) as a mask such that some phase shifting material (41) is deposited on said resist pattern (2), whereby the thickness of the phase shifting segment (42) is set depending on the amount of phase shifting material deposited; and
removing said resist pattern (2) together with phase shifting material (41) leaving the phase shifting segment (42) in said opening (10a).

## Patentansprüche

1. Verfahren zur Herstellung einer Phasenverschiebungsmaske mit den Verfahrensschritten:
Ausbilden einer lichtundurchlässigen Schicht (10') auf einem Substrat (1),
Ausbilden eines Fotoresists (2') auf der lichtundurchlässigen Schicht (10'),
Mustern des Fotoresists (2') zum Ausbilden eines Resistmusters (2),
Ausbilden einer Öffnung (10a) in der lichtundurchlässigen Schicht (10') unter Vewendung des Resistmusters (2) als Maske und dadurch Ausbilden eines lichtundurchlässigen Musters (10b),
Kantenätzen des lichtundurchlässigen Musters (10b) zum Ausbilden einer lichtundurchlässigen Region (10),
Ablagern eines Phasenverschiebungsmaterials in der genannten Öffnung (10a) zum Ausbilden eines Phasenverschiebungssegments (42), wobei das Resistmuster (2) als Maske verwendet wird, so daß etwas Phasenverschiebungsmaterial (41) auf dem Resistmuster (2) abgelagert wird, wobei die Dicke des Phasenverschiebungssegments (42) in Abhängigkeit von der Menge des abgelagerten Phasenverschiebungsmaterials eingestellt wird, und
Entfernen des Resistmusters (2) zusammen mit dem Phasenverschiebungsmaterial (41), wobei das Phasenverschiebungssegment (42) in der Öffnung (10a) belassen wird.

## Revendications

1. Procédé de fabrication d'un masque déphaseur, le procédé comprenant les étapes :
de formation d'une couche formant écran à la lumière (10') sur un substrat (1) ;
de formation d'un photorésist (2') sur ladite couche formant écran à la lumière (10') ;
de dessin dudit photorésist (2') pour former un motif de résist (2) ;
de formation d'une ouverture (10a) dans ladite couche formant écran à la lumière (10') en utilisant ledit motif de résist (2) comme masque, en formant ainsi un motif formant écran à la lumière (10b) ;
d'attaque latérale dudit motif formant écran à la lumière (10b) pour former une région formant écran à la lumière (10) ;
de dépôt d'une matière déphaseuse dans ladite ouverture (10a) pour former un segment déphaseur (42) en utilisant ledit motif de résist (2) comme masque, de façon à déposer une certaine matière déphaseuse (41) sur ledit motif de résist (2), l'épaisseur du segment déphaseur (42) étant ainsi fixée en fonction de la quantité de matière déphaseuse déposée ; et
d'élimination dudit motif de résist (2) en même temps que de la matière déphaseuse (41) en laissant le segment déphaseur (42) dans ladite ouverture (10a).
